# FASCICULE DE BREVET EUROPEEN

(11) **EP 2 471 713 B1**
(45) Date de publication et mention de la délivrance du brevet: **07.01.2015**
(21) Numéro de dépôt: 11190489.2
(22) Date de dépôt: 24.11.2011
(51) Int. Cl.: B64G 1/22, B64G 1/44

(54) **Générateur solaire déroulable caissonné**
Abwickelbarer kastenförmiger Solargenerator
Unreelable square framed solar generator

(30) Priorité: 30.12.2010 FR 1005178
(43) Date de publication de la demande: 04.07.2012
(73) Titulaire: Thales, 92200 Neuilly Sur Seine (FR)
(72) Inventeur: Blanchard, Laurent, 06370 Mouans-Sartoux (FR); Ducarne, Julien, 06400 Cannes (FR); Baudasse, Yannick, 06130 Grasse (FR)
(74) Mandataire: Esselin, Sophie

(56) Documents cités:
- US-A- 3 564 789
- US-A1- 2002 112 417
- US-A1- 2007 262 204

## Description

Le domaine de l'invention est celui des structures déployables dans l'espace pouvant avantageusement être utilisées pour le déploiement de générateurs solaires de très grande dimension.

Les mètres-rubans - tape-spring en anglais - sont connus en tant que tels dans le domaine spatial comme étant des rubans aptes à passer de l'état enroulé à l'état déroulé essentiellement grâce à leur énergie élastique propre ; à l'état déroulé, les mètres-rubans connus présentent généralement une rigidité apte à les maintenir dans cet état.

Le document US 2002/0112417 décrit un dispositif de déploiement comprenant des longerons flexibles qui peuvent être aplatis sous forme de ruban par chauffage. L'application de chaleur leur fait retrouver leur forme initiale.

Le document US 3564789 décrit une structure déployable à partir d'une forme enroulée.

Le document US 2007/0262204 décrit une structure formée de longerons déployables par l'action de la chaleur à partir d'une configuration enroulée et pouvant supporter des cellules solaires.

Les mètres-rubans classiques, généralement métalliques, ont donc une tendance naturelle à se déplier pour se retrouver dans leur état stable. Si on les force à se replier, ils ont tendance à le faire sur un rayon égal à celui de leur rayon de courbure transversale. Il faut donc un effort extérieur faible pour les maintenir enroulés sous cette forme. Si cet effort est brutalement supprimé, le dépliement peut être violent et incontrôlé, c'est-à-dire que tout le mètre-ruban peut avoir tendance à se remettre droit simultanément, sur toute sa longueur. Les mètres-rubans classiques peuvent ainsi présenter des difficultés en termes de contrôle de leur dépliement.

Des mètres-rubans classiques en matériau composite ont par ailleurs été mis au point. Ces derniers ont des propriétés similaires pour l'essentiel à celles des mètres-rubans classiques métallique, mais présentent l'avantage de rendre possible, dans une certaine mesure, le contrôle de leur rayon d'enroulement propre. Ils offrent également l'avantage d'un rapport rigidité / masse élevé ainsi que d'un faible coefficient de dilatation.

La demanderesse a déjà démontré que l'on peut associer un mètre-ruban classique à une couche de matériau thermoplastique. Cette invention a fait l'objet de la demande de brevet FR 0803986. Le mètre ruban classique comprenant une couche de matériau thermoplastique peut être enroulé en force, chauffé puis refroidi de telle sorte que le thermoplastique fige le mètre-ruban dans l'état enroulé, qui devient alors l'état stable. En chauffant localement, il est possible de dérouler progressivement l'ensemble.

Alternativement, il est possible d'utiliser à la place du matériau thermoplastique un matériau thermodurcissable ou plus généralement un matériau présentant une forte variation de rigidité au franchissement d'un seuil de température.
Enfin, par construction, il est possible de rendre un mètre-ruban composite bi-stable. Des études ont été publiées sur cette question, comme notamment « Carbon Fibre Reinforced Plastic Tape Springs », J.C.H. Yee et Al., AIAA 2004-1819, et « Analytical models for bistable cylindrical shells », S.D. Guest et Al.

La propriété remarquable des mètres-rubans bi-stables réside dans le fait qu'ils sont mécaniquement stables à la fois à l'état déroulé et à l'état enroulé. L'état le plus stable reste cependant l'état déroulé. Les mètres-rubans bi-stables sont enroulés par l'intermédiaire d'un effort généralement important. Ils restent stables à l'état enroulés autour de leur rayon de courbure naturel, sans effort extérieur. Il suffit d'en déplier une extrémité, avec un effort de faible intensité, exercé par un système de motorisation par exemple, pour déclencher le déroulement. Le déroulement peut être très rapide, mais reste progressif à partir du point de déroulement initial.

Dans ce contexte, la problématique générale à laquelle a trait l'invention réside dans le déploiement de générateurs solaires de très grande dimension et à la manière de déployer une structure de renfort tridimensionnelle pour supporter des générateurs solaires présentant une surface très importante.

L'état de la technique ne propose pas de solution technologique satisfaisante et la présente invention cherche à pallier cette carence.

L'invention consiste donc en un dispositif de déploiement de générateur solaire comprenant au moins un mètre-ruban primaire supportant une membrane souple, semi-rigide, ou composée d'éléments souples et rigides tels que de fines lattes planes reliées de manière flexible entre elles, ladite membrane ayant une face sur laquelle sont agencées un ensemble d'éléments aptes à transformer l'énergie solaire en énergie électrique. Le dispositif selon l'invention comporte en outre au moins un mètre-ruban secondaire, et une structure de renfort rattachée à la fois audit au moins un mètre-ruban primaire et audit au moins un mètre-ruban secondaire, ledit dispositif présentant un état enroulé dans lequel ledit au moins un mètre-ruban primaire supportant la membrane et ledit au moins un mètre-ruban secondaire ainsi que la structure de renfort sont co-enroulés autour d'un mandrin, et un état déroulé dans lequel ledit au moins un mètre-ruban primaire et ledit au moins un mètre-ruban secondaire sont déroulés, et en ce que ledit dispositif comprend au niveau dudit mandrin des moyens pour décaler, dans l'état déroulé, l'emplanture dudit au moins un mètre ruban secondaire de telle manière que ladite structure de renfort est déployée dans le volume situé du côté opposé à la face de la membrane comprenant les éléments aptes à transformer l'énergie solaire en énergie électrique et supporte ladite membrane souple, le dispositif se trouvant alors dans l'état déployé.

Lesdits moyens de décalage consistent en un élément mobile lié au mandrin auquel est fixé ledit au moins un mètre-ruban secondaire et pas ledit au moins un mètre-ruban primaire ou, respectivement, ledit au moins un mètre-ruban primaire et pas ledit au moins un mètre-ruban secondaire.

Avantageusement, ledit élément mobile est un mandrin secondaire de même axe que le mandrin, apte à effectuer, dans l'état déroulé, une rotation sur lui-même d'une fraction de tour de mandrin de manière à décaler l'emplanture dudit au moins un mètre-ruban secondaire ou, respectivement, l'emplanture dudit au moins un mètre-ruban primaire.

Selon un autre mode de réalisation, ledit élément mobile consiste en un actionneur mécanique apte à décaler l'emplanture dudit au moins un mètre ruban secondaire ou, respectivement, l'emplanture dudit au moins un mètre-ruban primaire, par rapport au mandrin.

Avantageusement, la structure de renfort peut comprendre un ensemble de câbles ou de biellettes.

Avantageusement, la structure de renfort peut comporter en outre un ensemble de lattes transversales.

Selon un mode de réalisation, le dispositif selon l'invention comprend deux structures de déploiement, permettant le déploiement de deux membranes souples, respectivement de par et d'autre du mandrin.

Avantageusement, pour une première membrane, les moyens de décalage permettent de décaler l'emplanture dudit au moins un mètre-ruban secondaire et, pour une deuxième membrane, les moyens de décalage permettent de décaler l'emplanture dudit au moins un mètre-ruban primaire.

Avantageusement, au moins un des mètre-rubans comprend une couche d'un matériau présentant une forte variation de rigidité au franchissement d'un seuil de température. Cela permet d'assurer le déploiement progressif de l'ensemble par chauffage.

D'autres caractéristiques et avantages de l'invention apparaîtront à l'aide de la description qui suit faite en regard des dessins annexés donnés à titre d'exemples non limitatifs qui représentent :
- la figure 1 : un exemple de dispositif selon l'invention en cours de déploiement, comprenant deux membranes revêtues de générateurs solaires, ainsi que leurs structures de renfort enroulées avec les membranes;
- la figure 2 : le même exemple de dispositif selon l'invention, à un stade de déploiement plus avancé que celui de la figure 1, la structure de renfort étant en cours de déploiement ;
- la figure 3 : le même exemple de dispositif selon l'invention déployé.

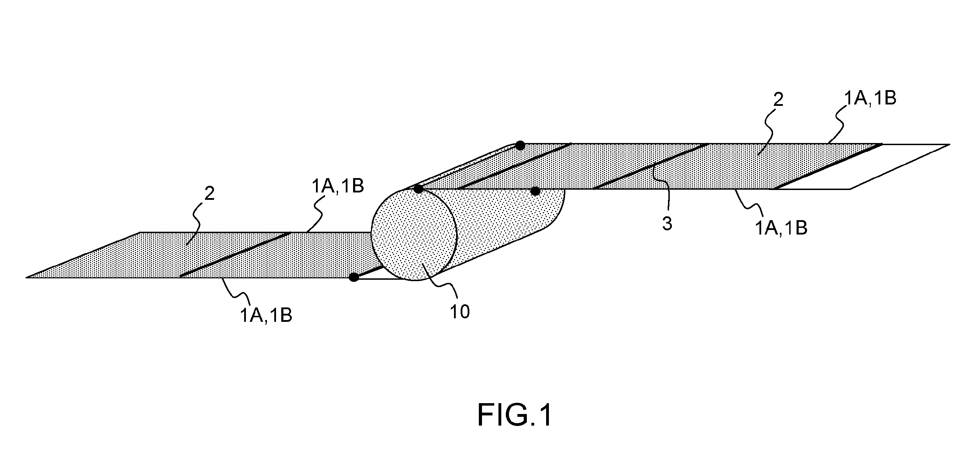

La figure 1 présente un schéma d'un exemple de dispositif selon l'invention, en cours de déploiement. Ce dernier comprend au moins une structure de déploiement d'une membrane souple 2, supportant une pluralité d'éléments aptes à transformer l'énergie solaire en énergie électrique, tels que des cellules photovoltaïques, sur une face. Ladite structure de déploiement comprend un ou une pluralité de mètres-rubans primaires 1A constituant un cadre supportant ladite membrane souple. Le dispositif selon l'invention peut, selon le mode de mise en oeuvre, permettre le déploiement de deux membranes souples 2 de part et d'autre d'un mandrin 10 - comme sur les figures - ou une seule membrane souple 2. Par ailleurs, alternativement, la membrane 2 peut être semi-rigide, ou être constituée d'éléments souples et rigides tels que de fines lattes planes reliées de manière flexibles entres elles.

A l'état enroulé, lesdits mètres-rubans primaires 1 A sont enroulés autour du mandrin 10, qui assure également une fonction de support d'enroulement pour la ou les membranes souples 2.

Dans le mode de réalisation représenté sur les figures 1 à 3, deux mètres-rubans primaires 1A constituent un cadre supportant la ou les membranes souples 2. Lesdits mètres-rubans primaires 1A, pour chaque membrane souple 2, sont de préférence reliés par des lattes transversales 3 afin d'assurer la rigidité de la structure.

Le dispositif de déploiement tel que représenté sur les figures comprend par ailleurs au moins un mètre ruban secondaire 1 B et une structure de renfort 20 co-enroulés, dans l'état enroulé, avec le mètre ruban primaire 1 A autour du mandrin 10, et situés sur la face de la membrane du côté opposé à la face comprenant les éléments aptes à transformer l'énergie solaire en énergie électrique.

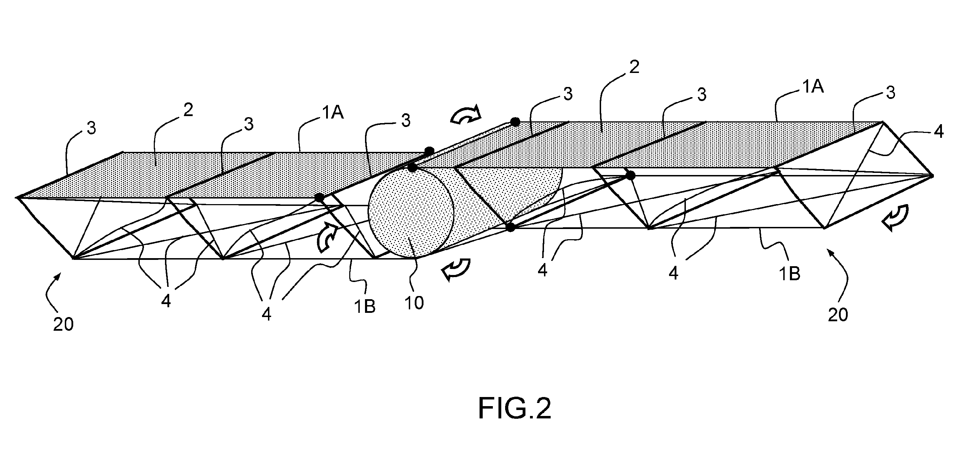

Comme représenté à la figure 2, dans un stade de déploiement plus avancé, le dispositif selon l'invention comporte ainsi une structure de renfort 20 en cours de déploiement et des mètres-rubans secondaires 1 B éloigné de la membrane souple 2 par la structure de renfort. La structure de renfort 20 relie entre eux les mètre-rubans secondaires 1 B par des lattes transversales de même constitution, ainsi que par d'éventuels câbles croisés 4 dont la fonction est de conforter le support des membranes souples 2, ce qui peut s'avérer indispensable lorsque ces dernières sont de très grande dimension.

La structure de renfort 20 est rattachée à la fois aux mètres-rubans primaires 1 A et aux mètres-rubans secondaires 1 B.

Le dispositif selon l'invention comprend par ailleurs au niveau dudit mandrin 10 des moyens pour décaler l'emplanture du ou des mètres-rubans secondaires 1 B ou l'emplanture du ou des mètres-rubans primaires 1A en fin de déploiement, de telle manière que ladite structure de renfort 20 se retrouve déployée dans le volume situé du côté opposé à la face de la membrane souple 2 comprenant des cellules photovoltaïques souples, et supporte ladite membrane souple 2

Une structure déployable mince est par nature relativement flexible et peut poser des problèmes pour la manoeuvrabilité du satellite de par ses modes de vibration à basse fréquence et de grande amplitude. La structure comprenant les rubans primaires et secondaires, séparés par une structure de renfort et décalés, permet d'obtenir une membrane souple reposant sur une structure constituant un treillis dont la raideur mécanique est bien supérieure à la raideur de la structure constituée des seuls mètres-rubans primaires. Les modes de vibration de la structure sont de fréquence plus élevée et d'amplitude moindre.

Lesdits moyens pour décaler l'emplanture dudit au moins un mètre ruban secondaire 1 B, respectivement l'emplanture du ou des mètres-rubans primaires 1A, sont rattachés au mandrin 10, et peuvent consister en un quelconque élément mobile auquel est fixé ledit au moins un mètre-ruban secondaire 1 B et pas ledit au moins un mètre-ruban primaire 1A, ou, respectivement, en un quelconque élément mobile auquel est fixé ledit au moins un mètre-ruban primaire 1A et pas ledit au moins un mètre-ruban secondaire 1A, ledit élément mobile se déplaçant alors que les mètres-rubans primaires 1 A et secondaires 1 B sont déroulés. Ainsi, dans le mode de réalisation préféré, représenté aux figures 1 à 3, le dispositif selon l'invention permet le déploiement de deux membranes souples 2, de part et d'autre du mandrin 10. Pour une première membrane souple 2, représentée à droite du mandrin 10 sur les figures, c'est l'emplanture du mètre-ruban secondaire 1 B qui est décalée en fin de déploiement, et réciproquement, pour une deuxième membrane souple 2, représentée à gauche du mandrin 10 sur les figures, c'est l'emplanture du mètre-ruban primaire 1A qui est décalée en fin de déploiement.

Selon un mode de réalisation préféré de l'invention, l'élément mobile mentionné ci-dessus est un mandrin secondaire de même axe que le mandrin 10, apte à effectuer, dans l'état déroulé, une rotation sur lui-même d'une fraction de tour de mandrin 10 de manière à décaler l'emplanture dudit au moins un mètre ruban secondaire 1 B et / ou dudit au moins un mètre-ruban primaire 1 A de la manière appropriée.

Selon un autre mode de réalisation, ledit élément mobile consiste en un actionneur mécanique apte à décaler l'emplanture dudit au moins un mètre ruban secondaire 1 B, et / ou, respectivement, l'emplanture dudit au moins un mètre-ruban primaire 1 A par rapport au mandrin 10.

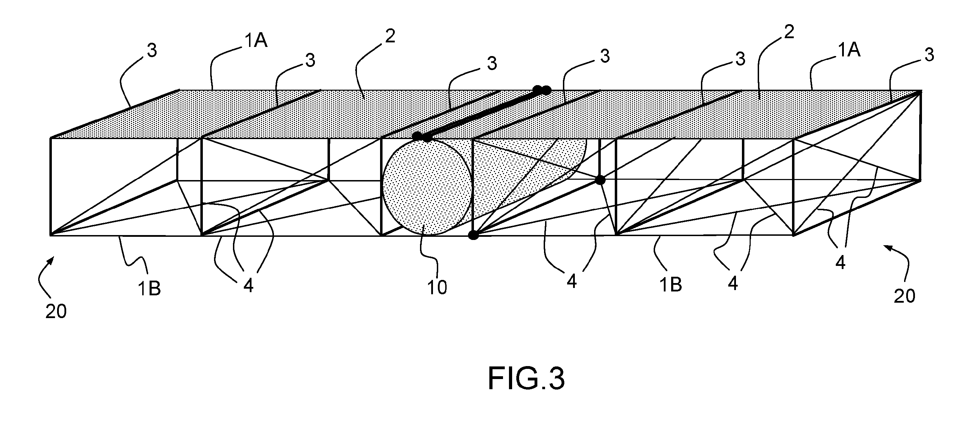

La figure 3 représente le dispositif selon l'invention en fin de déploiement, l'emplanture des mètres rubans secondaires 1 B ou primaires 1A étant décalée selon l'invention, c'est-à-dire que les rubans primaires 1A sont éloignés des rubans secondaires 1 B, en étant séparés par une structure de renfort 20.

L'invention propose ainsi un dispositif de déploiement de générateurs solaires enroulables, présentant une structure de renfort tridimensionnelle apte au support de générateurs solaires de grande dimension, et à l'encombrement réduit.

## Revendications

1. Dispositif de déploiement d'au moins une membrane (2) sur une face de laquelle sont agencées un ensemble d'éléments aptes à transformer l'énergie solaire en énergie électrique,
ledit dispositif étant constitué d'une structure de déploiement par membrane (2) à déployer,
ladite structure de déploiement comprenant au moins un mètre-ruban primaire (1A) supportant ladite membrane,
ledit dispositif comportant en outre au moins un mètre-ruban secondaire (1 B), et une structure de renfort (20) rattachée à la fois audit au moins un mètre-ruban primaire (1A) et audit au moins un mètre-ruban secondaire (1 B),
ledit dispositif présentant un état enroulé dans lequel ledit au moins un mètre ruban primaire (1A) supportant la membrane (2) et ledit au moins un mètre-ruban secondaire (1 B) ainsi que la structure de renfort (20) sont co-enroulés autour d'un mandrin (10),
et un état déroulé dans lequel ledit au moins un mètre-ruban primaire (1A) et ledit au moins un mètre-ruban secondaire (1 B) sont déroulés,
**caractérisé en ce que** ledit dispositif comprend au niveau dudit mandrin (10) des moyens de décalage pour décaler, dans l'état déroulé, l'emplanture dudit au moins un mètre-ruban secondaire (1 B) ou dudit au moins un mètre-ruban primaire (1A) de telle manière que ladite structure de renfort (20) est déployée dans le volume situé du côté opposé à la face de la membrane (2) comprenant les éléments aptes à transformer l'énergie solaire en énergie électrique, et supporte ladite membrane (2), le dispositif se trouvant alors dans l'état déployé,
lesdits moyens de décalage étant rattaché au mandrin (10) et comprenant un élément mobile auquel est fixé exclusivement soit ledit mètre ruban primaire (1A) soit ledit mètre ruban secondaire (1B).

2. Dispositif selon la revendication 1, **caractérisé en ce que** ledit élément mobile est un mandrin secondaire de même axe que le mandrin (10), apte à effectuer, dans l'état déroulé, une rotation sur lui-même d'une fraction de tour de mandrin (10) de manière à décaler l'emplanture dudit au moins un mètre-ruban secondaire (1 B) ou, respectivement, l'emplanture dudit au moins un mètre-ruban primaire (1 A).

3. Dispositif selon la revendication 1, **caractérisé en ce que** ledit élément mobile consiste en un actionneur mécanique apte à décaler l'emplanture dudit au moins un mètre ruban secondaire (1 B) ou, respectivement, l'emplanture dudit au moins un mètre-ruban primaire (1A), par rapport au mandrin (10).

4. Dispositif selon l'une quelconque des revendications précédentes, **caractérisé en ce que** la structure de renfort (20) comprend un ensemble de câbles ou de biellettes (4).

5. Dispositif selon la revendication 4, **caractérisé en ce que** la structure de renfort (20) comporte en outre un ensemble de lattes transversales.

6. Dispositif selon l'une des revendications précédentes, **caractérisé en ce qu'**il comprend deux structures de déploiement, permettant le déploiement de deux membranes souples (2), respectivement de par et d'autre du mandrin (10).

7. Dispositif selon la revendication 6, **caractérisé en ce que**, pour une première membrane (2), les moyens de décalage permettent de décaler l'emplanture dudit au moins un mètre-ruban secondaire (1 B) et, pour une deuxième membrane (2), les moyens de décalage permettent de décaler l'emplanture dudit au moins un mètre-ruban primaire (1 A).

8. Dispositif selon l'une des revendications précédentes, **caractérisé en ce que** ladite membrane (2) est souple.

9. Dispositif selon l'une des revendications 1 à 7, **caractérisé en ce que** ladite membrane (2) est semi rigide.

10. Dispositif selon l'une des revendications 1 à 7, **caractérisé en ce que** ladite membrane (2) est composée d'éléments souples et rigides.

11. Dispositif selon la revendication 10, **caractérisé en ce que** lesdits éléments souples et rigides consistent en de fines lattes planes reliées de manière flexible entre elles.

12. Dispositif selon l'une des revendications précédentes, **caractérisé en ce que** lesdits éléments aptes à transformer l'énergie solaire en énergie électrique sont des cellules photovoltaïques souples.

13. Dispositif selon l'une des revendications précédentes, **caractérisé en ce que** au moins un des mètres rubans (1A, 1 B) comprend une couche d'un matériau présentant une forte variation de rigidité au franchissement d'un seuil de température.

## Patentansprüche

1. Vorrichtung zum Entfalten von wenigstens einer Membran (2), auf deren einer Fläche ein Satz von Elementen angeordnet ist, die Solarenergie in elektrische Energie umwandeln können,
wobei die Voriichtung von einer Entfaltungsstruktur pro zu entfaltender Membran (2) gebildet wird,
wobei die Entfaltungsstruktur wenigstens ein primäres Federband (1A) umfasst, das die Membran trägt,
wobei die Vorrichtung ferner wenigstens ein sekundäres Federband (1B) und eine Verstärkungsstruktur (20) umfasst, die sowohl an dem wenigstens einen primären Federband (1A) als auch an dem wenigstens einen sekundären Federband (1B) angebracht ist,
wobei die Vorrichtung einen gewickelten Zustand hat, in dem das die Membran (2) tragende wenigstens eine primäre Federband (1A) und das wenigstens eine sekundäre Federband (1B) sowie die Verbindungsstruktur (20) zusammen um eine Hülse (10) gewickelt sind,
und einen abgewickelten Zustand, in dem das wenigstens eine primäre Federband (1A) und das wenigstens eine sekundäre Federband (1B) abgewickelt sind,
**dadurch gekennzeichnet, dass** die Vorrichtung an der Hülse (10) Versatzmittel zum Versetzen, im abgewickelten Zustand, des Ansatzes des wenigstens einen sekundären Federbands (1B) oder des wenigstens einen primären Federbands (1A) auf eine solche Weise umfasst, dass die Verstärkungsstruktur (20) in dem Raum auf der Seite gegenüber der Fläche der Membran (2) entfaltet wird, die die Elemente zum Umwandeln von Solarenergie in elektrische Energie umfasst und die Membran trägt (2), wobei sich die Vorrichtung dann im entfalteten Zustand befindet,
wobei die Versatzmittel an der Hülse (10) angebracht sind und ein bewegliches Element umfassen, an dem nur entweder das primäre Federband (1A) oder das sekundäre Federband (1B) fixiert ist.

2. Vorrichtung nach Anspruch 1, **dadurch gekennzeichnet, dass** das bewegliche Element eine sekundäre Hülse mit derselben Achse ist wie die Hülse (10) und im abgewickelten Zustand eine Rotation um sich selbst um einen Bruchteil einer Umdrehung der Hülse (10) ausführen kann, um den Ansatz des wenigstens einen sekundären Federbands (1B) bzw. den Ansatz des wenigstens einen primären Federbands (1A) zu versetzen.

3. Vorrichtung nach Anspruch 1, **dadurch gekennzeichnet, dass** das bewegliche Element einen mechanischen Aktuator zum Versetzen des Ansatzes des wenigstens einen sekundären Federbands (1B) bzw. des Ansatzes des wenigstens einen primären Federbands (1A) relativ zu der Hülse (10) umfasst.

4. Vorrichtung nach einem der vorherigen Ansprüche, **dadurch gekennzeichnet, dass** die Verstärkungsstruktur (20) einen Satz von Seilen oder Armen (4) umfasst.

5. Vorrichtung nach Anspruch 4, **dadurch gekennzeichnet, dass** die Verstärkungsstruktur (20) einen Satz Querleisten umfasst.

6. Vorrichtung nach einem der vorherigen Ansprüche, **dadurch gekennzeichnet, dass** sie zwei Entfaltungsstrukturen umfasst, die die Entfaltung von zwei flexiblen Membranen (2) jeweils auf beiden Seiten der Hülse (10) zulässt.

7. Vorrichtung nach Anspruch 6, **dadurch gekennzeichnet, dass** die Versatzmittel für eine erste Membran (2) das Versetzen des Ansatzes des wenigstens einen sekundären Federbands (1B) zulassen und für eine zweite Membran (2) das Versetzen des Ansatzes des wenigstens einen primären Federbands (1A) zulassen.

8. Vorrichtung nach einem der vorherigen Ansprüche, **dadurch gekennzeichnet, dass** die Membran (2) flexibel ist.

9. Vorrichtung nach einem der Ansprüche 1 bis 7, **dadurch gekennzeichnet, dass** die Membran (2) halbstarr ist.

10. Vorrichtung nach einem der Ansprüche 1 bis 7, **dadurch gekennzeichnet, dass** die Membran (2) aus flexiblen und starren Elementen besteht.

11. Vorrichtung nach Anspruch 10, **dadurch gekennzeichnet, dass** die flexiblen und starren Elemente aus dünnen, flachen Leisten gebildet sind, die flexibel miteinander verbunden sind.

12. Vorrichtung nach einem der vorherigen Ansprüche, **dadurch gekennzeichnet, dass** die Elemente zum Umwandeln von Solarenergie in elektrische Energie flexible photovoltaische Zellen sind.

13. Vorrichtung nach einem der vorherigen Ansprüche, **dadurch gekennzeichnet, dass** wenigstens eines der Federbänder (1A, 1B) eine Schicht aus einem Material mit einer hohen Starrheitsvariation beim Überqueren einer Temperaturschwelle umfasst.

## Claims

1. A device for deploying at least one membrane (2), with a set of elements being arranged on a face of said membrane, said elements being designed to convert solar energy into electric energy,
said device being formed by one deployment structure per membrane (2) to be deployed,
said deployment structure comprising at least one primary tape spring (1A) supporting said membrane,
said device further comprising at least one secondary tape spring (1B) and a reinforcing structure (20) attached both to said at least one primary tape spring (1A) and to said at least one secondary tape spring (1B),
said device having a wound state in which said at least one primary tape spring (1A) supporting said membrane (2) and said at least one secondary tape spring (1B), as well as said reinforcing structure (20) are co-wound about a mandrel (10),
and an unwound state in which said at least one primary tape spring (1A) and said at least one secondary tape spring (1B) are unwound,
**characterised in that** said device comprises, at said mandrel (10), offsetting means for offsetting, in the unwound state, the attachment area of said at least one secondary tape spring (1B) or of said at least one primary tape spring (1A) in such a way that said reinforcing structure (20) is deployed in the space located on the side opposite the face of said membrane (2) comprising the elements designed to convert solar energy into electric energy and supports said membrane (2), said device then being found in the deployed state,
said offsetting means being attached to said mandrel (10) and comprising a movable element to which only either said primary tape spring (1A) or said secondary tape spring (1B) is fixed.

2. The device according to claim 1, **characterised in that** said movable element is a secondary mandrel with the same axis as said mandrel (10), which secondary mandrel is designed to perform, in the unwound state, a rotation about itself by a fraction of a revolution of said mandrel (10) so as to offset the attachment area of said at least one secondary tape spring (1B) or, respectively, the attachment area of said at least one primary tape spring (1A).

3. The device according to claim 1, **characterised in that** said movable element comprises a mechanical actuator designed to offset the attachment area of said at least one secondary tape spring (1B) or, respectively, the attachment area of said at least one primary tape spring (1A) relative to said mandrel (10).

4. The device according to any one of the preceding claims, **characterised in that** said reinforcing structure (20) comprises a set of cables or of links (4).

5. The device according to claim 4, **characterised in that** said reinforcing structure (20) further comprises a set of transverse battens.

6. The device according to any one of the preceding claims, **characterised in that** it comprises two deployment structures allowing the deployment of two flexible membranes (2), respectively, on both sides of said mandrel (10).

7. The device according to claim 6, **characterised in that**, for a first membrane (2), said offsetting means allow the attachment area of said at least one secondary tape spring (1B) to be offset and, for a second membrane (2), said offsetting means allow the attachment area of said at least one primary tape spring (1A) to be offset.

8. The device according to any one of the preceding claims, **characterised in that** said membrane (2) is flexible.

9. The device according to any one of claims 1 to 7, **characterised in that** said membrane (2) is semi-rigid.

10. The device according to any one of claims 1 to 7, **characterised in that** said membrane (2) is comprised of flexible and rigid elements.

11. The device according to claim 10, **characterised in that** said flexible and rigid elements are formed by thin, flat battens that are flexibly connected together.

12. The device according to any one of the preceding claims, **characterised in that** said elements designed to convert solar energy into electric energy are flexible photovoltaic cells.

13. The device according to any one of the preceding claims, **characterised in that** at least one of said tape springs (1A, 1B) comprises a layer of a material with a high variation in rigidity upon crossing a temperature threshold.
